# EUROPEAN PATENT APPLICATION

(11) **EP 3 778 075 A1**
(43) Date of publication of application: **17.02.2021**
(21) Application number: 19777787.3
(22) Date of filing: 22.03.2019
(51) Int. Cl.: B22F 3/11, B22F 1/00, B22F 7/08, C22C 1/08, H01L 21/52

(54) **SINTERED POROUS SILVER FILM AND PRODUCTION METHOD FOR JOINT BODY**

(30) Priority: 28.03.2018 JP 2018061321; 18.03.2019 JP 2019050381
(71) Applicant: Mitsubishi Materials Corporation, Tokyo 100-8117 (JP)
(72) Inventor: MASUYAMA Kotaro, Naka-shi, Ibaraki 311-0102 (JP); YAMASAKI Kazuhiko, Naka-shi, Ibaraki 311-0102 (JP)
(74) Representative: Hoffmann Eitle
(86) International application number: PCT/JP2019/012119
(87) International publication number: WO 2019/188793

(57) **Abstract**

This sintered porous silver film is obtained by sintering silver particles, wherein a crystallite size is 60 nm to 150 nm, a ratio of a detected amount of C₃H₇⁺ ions to a detected amount of Ag⁺ ions which are measured by time-of-flight secondary ion mass spectrometry is 0.10 to 0.35, and a ratio of a detected amount of C₂H⁻ ions to the detected amount of Ag⁻ ions which are measured by time-of-flight secondary ion mass spectrometry is 0.9 to 3.7.

## Description

### TECHNICAL FIELD

The present invention relates to a sintered porous silver film and a method for producing a joined body (joint body) using the same.

The present application claims priority on Japanese Patent Application No. 2018-061321 filed on March 28, 2018, and Japanese Patent Application No. 2019-050381 filed on March 18, 2019, the contents of which are incorporated herein by reference.

### BACKGROUND ART

In the processes of assembling and mounting electronic components such as LED (light emitting diode) elements and power semiconductor chips, in the case of producing a joined body in which two or more components are joined, a joining material is generally used. Regarding such a joining material, a silver paste obtained by dispersing a silver powder in an organic solvent is known. This silver paste joins components as follows: a first component and a second component are laminated with the silver paste interposed therebetween, and the obtained laminated body is heated; and thereby, silver particles in the silver paste are sintered to form a joining layer (sintered body of the silver particles). For example, Patent Document 1 discloses a paste-like joining material which includes: a fine silver powder having a first peak within a particle size range of 20 to 70 nm and a second peak within a particle size range of 200 to 500 nm in the particle size distribution; a predetermined alkylamine; and a reducing organic solvent.

Furthermore, as the joining material, a sintered porous silver film in which silver particles are partially sintered is also known. A first component and a second component are laminated with this sintered porous silver film interposed therebetween. The obtained laminated body is heated; and thereby, the silver particles in the sintered porous silver film are further sintered to form a joining layer (sintered body of silver particles), and as a result, the components are joined. For example, Patent Document 2 discloses a sheet made of porous silver which is a self-supporting film formed of porous silver that is a porous body of silver and having a degree of compactness of 40% to 72% by volume, wherein the average crystal grain size of silver crystals in the porous silver is 1.7 to 2.6 µm, the flexural modulus obtained by a three-point bending test at 25°C is 16 to 24 GPa, the maximum bending strength is 100 MPa or more, and the bending strain at break is 1.3% or higher.

The sintered porous silver film has an advantage that the organic solvent does not volatilize during heating at the time of producing a joined body, as compared to a silver paste. However, since the sheet made of porous silver described in Patent Document 2 has an average crystal grain size of silver crystals of 1.7 to 2.6 µm which is relatively large, there have been cases in which, during heating at a low temperature of 200°C, for example, silver particles are not easily sintered, and it may be difficult to form a joining layer that is dense and has high joining strength.

### PRIOR ART DOCUMENTS

### Patent Document

Patent Document 1: Japanese Unexamined Patent Application, First Publication No. 2017-111975
Patent Document 2: Japanese Unexamined Patent Application, First Publication, No. 2016-169411

### DISCLOSURE OF INVENTION

### Problems to be Solved by the Invention

The present invention was achieved in view of the above-described circumstances, and an object of the invention is to provide a sintered porous silver film that can form a silver particle sintered body (joining layer), which is dense and has a high joining strength, by heating at a relatively low temperature, and a method for producing a joined body using this sintered porous silver film.

### Solutions for Solving the Problems

In order to solve the above-described problems, the sintered porous silver film according to an aspect of the present invention is a sintered porous silver film obtained by sintering silver particles, wherein a crystallite size is in a range of 60 nm to 150 nm, a ratio of a detected amount of C₃H₇⁺ ions to a detected amount of Ag⁺ ions (ratio of C₃H₇⁺ ions / Ag⁺ ions) which are measured by time-of-flight secondary ion mass spectrometry is in a range of 0.10 to 0.35, and a ratio of a detected amount of C₂H⁻ ions to the detected amount of Ag⁻ ions (ratio of C₂H⁻ ions / Ag⁻ ions) which are measured by time-of-flight secondary ion mass spectrometry is in a range of 0.9 to 3.7.

With regard to the sintered porous silver film according to an aspect of the present invention having these features, since the crystallite size is within the above-described range, the sintered porous silver film can be handled as a self-supporting joining material having high strength. Furthermore, the sintered porous silver film has high sinterability and can form a dense silver particle sintered body having high joining strength through heating at a relatively low temperature. Moreover, since the C₃H₇⁺ ion / Ag⁺ ion ratio and the C₂H⁻ ion / Ag⁻ ion ratio are respectively adjusted within the above-described ranges, the surface of the sintered porous silver film is not easily sulfurized, and the sinterability can be maintained for a long period of time. Therefore, it is possible to form a dense silver particle sintered body having high joining strength more reliably by heating at a relatively low temperature.

A method for producing a joined body according to an aspect of the present invention is a method for producing a joined body in which a first member and a second member are joined, the method includes: a step of laminating the first member and the second member with the above-mentioned sintered porous silver film interposed therebetween, and thereby obtaining a laminated body; and a step of heating the laminated body.

With regard to the method for producing a joined body according to an aspect of the present invention having these features, since the above-described sintered porous silver film is used as a joining material, it is possible to produce a joined body having high joining strength (shear strength) by heating at a relatively low temperature.

### Effects of Invention

According to an aspect of the present invention, it is possible to provide a sintered porous silver film capable of forming a dense silver particle sintered body (joining layer) having high joining strength by heating at a relatively low temperature, and a method for producing a joined body using this sintered porous silver film.

### BRIEF DESCRIPTION OF DRAWINGS

FIG. 1 is a flowchart showing a method for producing a sintered porous silver film according to an embodiment of the present invention.
FIG. 2 is a cross-sectional view of a joined body according to an embodiment of the present invention.
FIG. 3 is a flowchart showing a method for producing a joined body according to an embodiment of the present invention.
FIG. 4 is an SEM photograph of a cross section of the sintered porous silver film produced in Invention Example 1.
FIG. 5 is an SEM photograph of a cross section of a joining layer portion in a joined body produced using the sintered porous silver film produced in Invention Example 1.

### EMBODIMENTS FOR CARRYING OUT THE INVENTION

Hereinafter, a sintered porous silver film and a method for producing a joined body, which are embodiments of the present invention, will be described in detail with reference to the attached drawings. Incidentally, in the drawings used in the following description, characterizing portions may be shown in an enlarged form for convenience, in order to make the features easy to understand, and the dimensional ratios of the constituent elements and the like are not restricted to be the same as the actual ones.

### <Sintered porous silver film>

The sintered porous silver film of the present embodiment is a sintered porous silver film obtained by sintering silver particles. That is, the sintered porous silver film is a porous body of silver including silver particles and a sintered body of silver particles. The crystallite size of silver constituting the sintered porous silver film is in a range of 60 nm to 150 nm. Further, the C₃H₇⁺ ion / Ag⁺ ion ratio (the ratio of the detected amount of C₃H₇⁺ ions to the detected amount of Ag⁺ ions measured by time-of-flight secondary ion mass spectrometry (TOF-SIMS)) is in a range of 0.10 to 0.35, and the C₂H⁻ ion / Ag⁻ ion ratio (the ratio of the detected amount of C₂H⁻ ions to the detected amount of Ag⁻ ions measured by TOF-SIMS) is in a range of 0.9 to 3.7. The unit of the detected amount of ions is represented by the number of counts of the intensity.

It is preferable that the sintered porous silver film is a porous body having a structure in which silver particles are partially sintered and continuous pores are formed between the partially sintered silver particles. By heating this sintered porous silver film having a structure in which silver particles are partially sintered, sintering of the silver particles proceeds further, and a dense silver particle sintered body (joining layer) having high joining strength can be formed.

Since the crystallite size of the sintered porous silver film is 60 nm or more, the sintered porous silver film has high strength and can be handled as a self-supporting joining material. Furthermore, since the crystallite size is 150 nm or less, the sintered porous silver film has high sinterability and can form a dense silver particle sintered body having high joining strength by heating at a relatively low temperature.

The crystallite size is a value determined from an X-ray diffraction pattern.

The sintered porous silver film has a C₃H₇⁺ ion / Ag⁺ ion ratio in a range of 0.10 to 0.35 and a C₂H⁻ ion / Ag⁻ ion ratio in a range of 0.9 to 3.7. It is considered that the C₃H₇⁺ ions and the C₂H⁻ ions originate from the organic compound coated on the surface of the sintered porous silver film. In the case where the C3H₇⁺ ion / Ag⁺ ion ratio is 0.10 or more and the C₂H⁻ ion / Ag⁻ ion ratio is 0.9 or more, the surface of the sintered porous silver film is not easily sulfurized due to the organic compound coated on the surface of the sintered porous silver film, and the sinterability of the silver particles can be maintained over a long period of time. In the case where the C₃H₇⁺ ion / Ag⁺ ion ratio is 0.35 or less and the C₂H⁻ ion / Ag⁻ ion ratio is 3.7 or less, deterioration of the sinterability of the sintered porous silver film is suppressed by the organic compound coated on the surface of the sintered porous silver film, and a dense silver particle sintered body having high joining strength can be formed by heating at a relatively low temperature.

The C₃H₇⁺ ion / Ag+ ion ratio is preferably in a range of 0.20 to 3.5, and the C₂H⁻ ion / Ag⁻ ion ratio is preferably in a range of 2.5 to 3.7.

It is preferable that the sintered porous silver film has a filling ratio in a range of 50% to 70%. In the case where the filling ratio is 50% or more, the strength of the sintered porous silver film becomes high, and handling thereof becomes easy. Furthermore, in the case where the filling ratio is 70% or less, the sinterability of the silver particles becomes high, and a dense silver particle sintered body having high joining strength can be formed by heating at a low temperature. From the viewpoint of the joining strength of the sintered porous silver film, the filling ratio is more preferably 55% or more. Furthermore, from the viewpoint of sinterability, the filling ratio is preferably 65% or less.

The filling ratio of the sintered porous silver film is a value determined from a cross-sectional image of the sintered porous silver film.

### <Method for producing sintered porous silver film>

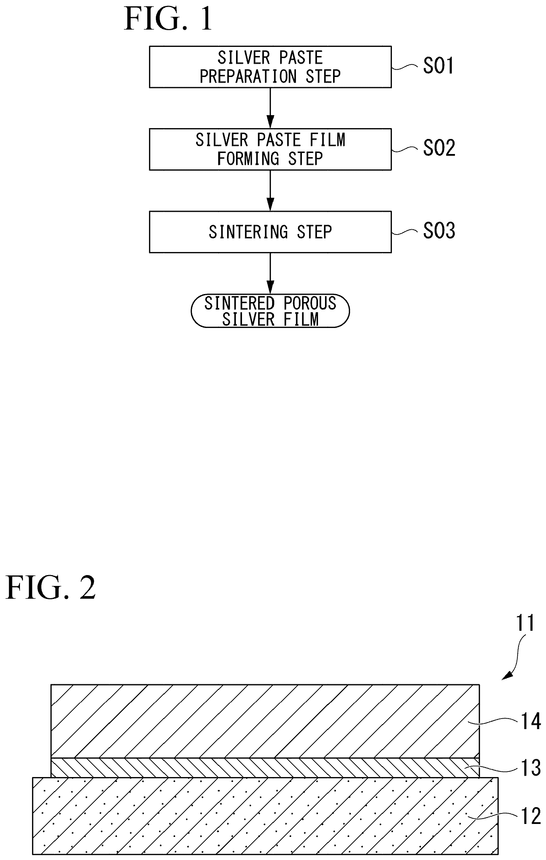

Next, the method for producing a sintered porous silver film of the present embodiment will be described. FIG. 1 is a flow chart showing the method for producing a sintered porous silver film according to an embodiment of the present invention.

As shown in FIG. 1, the method for producing a sintered porous silver film of the present embodiment includes silver paste preparation step SOI, silver paste film forming step S02, and sintering step S03.

### (Silver paste preparation step S01)

In the silver paste preparation step S01, a silver powder as a raw material and an organic solvent are kneaded; and thereby, a silver paste is prepared.

It is preferable that the silver powder has an average particle size of silver particles in a range of 40 nm to 100 nm. It is also preferable for the silver powder that the C3H₃O3⁻ ion / Ag⁺ ion ratio (the ratio of the detected amount of C3H₃O3⁻ ions to the detected amount of Ag⁺ ions measured by TOF-SIMS) is in a range of 0.2 to 1.0, and the C₆H₆O₈⁻ ion / Ag⁺ ion ratio (the ratio of the detected amount of C₆H₆O₈⁻ ions to the detected amount of Ag⁺ ions measured by TOF-SIMS) is in a range of 0.005 to 0.02. The C₃H₃O₃⁻ ion / Ag⁺ ion ratio is more preferably in a range of 0.2 to 0.5. The C₆H₆O₈⁻ ion / Ag⁺ ion ratio is more preferably in a range of 0.005 to 0.01.

A sintered porous silver film having high sinterability can be obtained by partially sintering a silver powder in which the average particle size of silver particles is within the above-described range, in the sintering step S03 that will be described later. In the caser where a silver powder having the C₃H₃O₃- ion / Ag⁺ ion ratio and the C₆H₆O₈⁻ ion / Ag⁺ ion ratio respectively within the above-described ranges is used, excessive sintering of silver particles in the sintering step S03 that will be described later can be suppressed, and it is possible to obtain a sintered porous silver film in which silver particles are partially sintered.

The above-described silver powder is produced by, for example, the following method. An aqueous solution of a silver salt and an aqueous solution of a carboxylic acid are simultaneously dripped into water; and thereby, silver carboxylate particles are produced, and thus a silver carboxylate slurry is prepared. Next, an aqueous solution of a reducing agent is dripped to the prepared silver carboxylate slurry; and thereby a mixed slurry is obtained. By retaining the obtained mixed slurry at a temperature in a range of 92°C to 95°C, the silver carboxylate particles are reduced to produce silver particles, and thus a silver powder slurry is prepared. Then, the prepared silver powder slurry is dried; and thereby, a silver powder is obtained. According to this production method, organic matters originating from the carboxylic acid adhere to the surfaces of the silver particles that are produced, and a silver powder in which the C₃H₃O₃⁻ ion / Ag⁺ ion ratio and the C₆H₆O₈⁻ ion / Ag⁺ ion ratio detected by TOF-SIMS are respectively in the above-described ranges, can be obtained.

As the aqueous solution of a silver salt, for example, an aqueous solution of a silver salt such as silver nitrate, silver chlorate, or silver phosphate can be used. One of these silver salts may be used, or a combination of two or more kinds thereof may be used.

The aqueous solution of a carboxylic acid contains a carboxylic acid or a carboxylic acid salt. As the carboxylic acid, for example, glycolic acid, citric acid, malic acid, maleic acid, malonic acid, fumaric acid, succinic acid, or tartaric acid can be used. As the carboxylic acid salt, an ammonium salt or an alkali metal salt of these carboxylic acids can be used. One of these carboxylic acids and carboxylic acid salts may be used, or a combination of two or more kinds thereof may be used.

It is preferable that the proportion of the amount of the aqueous solution of a silver salt and the amount of the aqueous solution of a carboxylic acid, which are simultaneously dripped into water, is adjusted to be in a range of 1.1 to 2.0 as the equivalent ratio of silver and the carboxylic acid [= (valence of silver ion: monovalence × number of moles) / (valence of carboxylic acid × number of moles)]. In this case, as the amount of free carboxylic acid in water increases concomitantly with the progress of dripping addition, the time required from the dripping addition of the aqueous solution of the silver salt until the generation of silver carboxylate particles is shortened; and therefore, silver carboxylate particles having a small particle size are likely to be produced. As the water, it is preferable to use water including a small amount of ions that may adversely affect the production of silver carboxylate particles, such as ion-exchanged water or distilled water.

As the aqueous solution of a reducing agent to be added to the silver carboxylate slurry, for example, aqueous solutions of reducing agents such as hydrazine, ascorbic acid, oxalic acid, formic acid, and salts thereof can be used. As the salts, ammonium salts and alkali metal salts can be used. One of these reducing agents may be used, or a combination of two or more kinds thereof may be used.

In the above-mentioned method for producing a silver powder, an aqueous solution of a reducing agent is dripped to a silver carboxylate slurry; and thereby, a mixed slurry is obtained. By adjusting the retention temperature of the obtained mixed slurry to 92°C or higher, the silver carboxylate is easily reduced, and silver particles can be rapidly produced. Furthermore, by adjusting the retention temperature of the mixed slurry to 95°C or lower, the carboxylic acid can be adhered as C₃H₃O₃⁻ ion or C₆H₆O₈⁻ ion to the surfaces of the produced silver particles; and therefore, the silver particles can be prevented from becoming coarse particles. It is preferable that the time for retaining the mixed slurry at the above-described temperature is in a range of 0.25 hours to 0.5 hours. By adjusting the retention time to 0.25 hours or longer, silver carboxylate can be reliably reduced, and silver particles can be produced stably. Furthermore, by adjusting the retention time to 0.5 hours or shorter, the produced silver particles can be prevented from becoming coarse particles. The retention time is preferably in a range of 0.33 hours to 0.5 hours.

It is preferable that the prepared silver powder slurry is cooled rapidly in order to prevent silver particles from becoming coarse particles. It is preferable that cooling of the silver powder slurry is carried out at a rate of temperature decrease (cooling rate) at which the time for lowering the temperature to 30°C is 15 minutes or less.

As a method for drying the silver powder slurry, for example, a freeze-drying method, a reduced-pressure drying method, or a heat-drying method can be used. Before the silver powder slurry is dried, it is preferable to remove water in the silver powder slurry by a centrifuge or decantation.

The organic solvent of the silver paste is not particularly limited as long as the organic solvent can be removed by evaporation in the sintering step S03 that will be described later. As the organic solvent, for example, an alcohol-based solvent, a glycol-based solvent, an acetate-based solvent, a hydrocarbon-based solvent, or an amine-based solvent can be used. Examples of the alcohol-based solvent include α-terpineol and isopropyl alcohol. Examples of the glycol-based solvent include ethylene glycol, diethylene glycol, and polyethylene glycol. Examples of the acetate-based solvent include butyl carbitol acetate. Examples of the hydrocarbon-based solvent include decane, dodecane, and tetradecane. Examples of the amine-based solvent include hexylamine, octylamine, and dodecylamine. One of these organic solvents may be used, or a combination of two or more kinds thereof may be used.

When the amount of the silver paste is taken as 100% by mass, the amount of silver particles in the silver paste is preferably in a range of 70% by mass to 95% by mass. In the case where the amount is less than 70% by mass, the amount of the solvent becomes relatively large, the viscosity becomes too low, and thus there is a risk that the formability of the silver paste film may be greatly deteriorated in the silver paste film forming step S02 that will be described later. On the other hand, in the case where the amount of silver particles is more than 95% by mass, the viscosity of the silver paste becomes too high, and thus there is a risk that the fluidity of the silver paste may be greatly deteriorated and it may be difficult to form a silver paste layer.

### (Silver paste film forming step S02)

In the silver paste film forming step S02, a silver paste film is formed using the silver paste prepared in the silver paste preparing step S01. Specifically, the silver paste is applied on a substrate, and thus a silver paste film is formed. The film thickness of the silver paste film is preferably in a range of 10 µm to 100 µm.

As the substrate, a substrate that has a flat surface and is easily detachable from the sintered porous silver film produced in the sintering step S03, is preferred. As the substrate, a resin substrate, a metal substrate, or a ceramic substrate can be used. Examples of the resin substrate include a fluororesin substrate and a silicone resin substrate. Examples of the metal substrate include a copper substrate, an aluminum substrate, and a stainless steel substrate. Examples of the ceramic substrate include a glass substrate, an alumina substrate, a silicon oxide substrate, and a silicon nitride substrate.

The method for applying the silver paste is not particularly limited, and various methods that are used as methods for applying a silver paste can be used. Examples of the application method include a printing method, a dispensing method, a pin transfer method, a roll coating method, a dip coating method, an air knife coating method, a blade coating method, a wire bar coating method, a slide hopper coating method, an extrusion coating method, a curtain coating method, a spin coating method, a spray coating method, a gravure coating method, or a comma coating method can be used.

### (Sintering step S03)

In the sintering step S03, the silver paste film formed in the silver paste film forming step S02 is heated; and thereby, the solvent of the silver paste film is removed, and also, silver particles are partially sintered. Thus, a sintered porous silver film is produced. The heating temperature for the silver paste film is, for example, in a range of 100°C to 200°C. In the case where the heating temperature is too low, there is a risk that it may be difficult for the silver particles in the silver paste film to be sintered, the mechanical strength of the sintered porous silver film may be deteriorated, and the sintered porous silver film may not be handled as a self-supporting film. On the other hand, in the case where the heating temperature exceeds 200°C, sintering of the silver particles in the silver paste layer proceeds excessively, and there is a risk that the silver particles may undergo grain growth and the sinterability of the obtained sintered porous silver film may be deteriorated. The heating time is preferably 5 to 30 minutes.

### <Joined body>

Next, the joined body of the present embodiment will be described.

FIG. 2 is a cross-sectional view of a joined body that is an embodiment of the present invention.

As shown in FIG. 2, the joined body 11 includes a first member 12 and a second member 14 joined to one surface (top surface in FIG. 1) of the first member, with a joining layer 13 interposed therebetween.

As the first member 12, for example, an insulated circuit board such as a DBA (Direct bonded Aluminum) board or a DBC (Direct Bonded Copper) board can be used. Furthermore, as the second member 14, for example, an electronic device such as an LED element or a power semiconductor chip can be used.

The joining layer 13 is a silver particle sintered body formed by heating the above-described sintered porous silver film to sinter the silver particles.

### <Method for producing joined body>

Next, the method for producing a joined body of the present embodiment will be described.

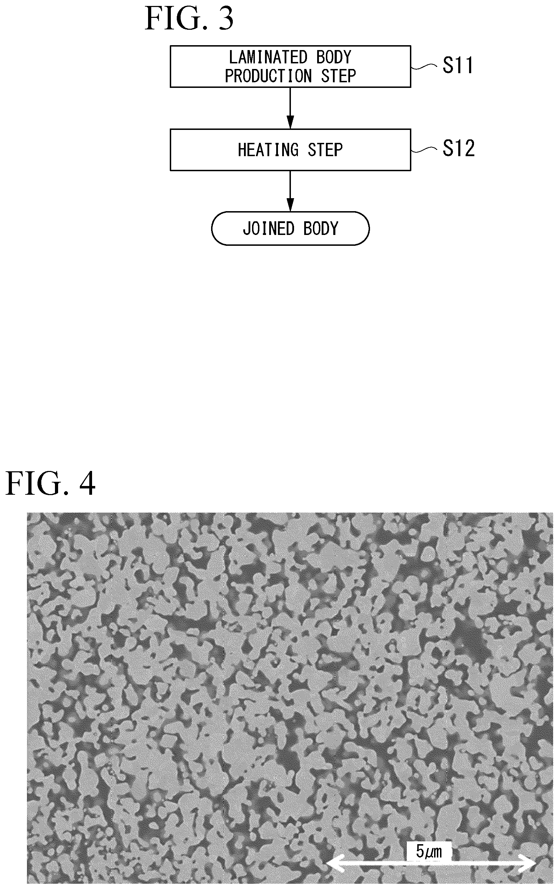

FIG. 3 is a flowchart showing a method for producing a joined body according to an embodiment of the present invention.

As shown in FIG. 3, the method for producing a joined body of the present embodiment includes laminated body production step S11 and heating step S12.

### (Laminated body production step S11)

In the laminated body production step S11, a first member 12 and a second member 14 are laminated, with a sintered porous silver film interposed therebetween; and thereby, a laminated body is produced. The laminated body can be produced by laminating the first member 12, the sintered porous silver film, and the second member 14 in this order.

It is preferable that the first member 12 and the second member 14 each have a coated film formed on the surface on the side that comes into contact with the sintered porous silver film, and the coated film has a high affinity with silver. The coated film is preferably a silver film or a gold film. As a method for forming the coated film, a plating method or a sputtering method can be used. By forming the coated film, the joining force between the joining layer 13 (silver particle sintered body) produced in the heating step S12 that will be described below and the first member 12 as well as the second member 14 increases, and thus the joining strength (shear strength) of the obtained joined body 11 is enhanced.

### (Heating step S12)

In the heating step S12, the laminated body obtained in the laminated body production step S01 is heated; and thereby, the silver particles in the sintered porous silver film are further sintered, and thus the joining layer 13 is formed. Thereby, the joined body 11 in which the first member 12 and the second member 14 are joined, with the joining layer 13 interposed therebetween, is obtained.

The heating temperature for the laminated body is, for example, in a range of 150°C to 250°C, and preferably in a range of 170°C to 230°C. In the case where the heating temperature is lower than 150°C, it is difficult for the silver particles in the sintered porous silver film to be sintered, and there is a risk that the joining layer 13 may not be formed. On the other hand, in the case where the heating temperature exceeds 250°C, there is a risk that the first member 12 and the second member 14 may be deteriorated by heat.

It is preferable that heating of the laminated body is performed while applying pressure in the direction of lamination (stacking direction) of the laminated body. The direction of lamination is a direction perpendicular to the surfaces where the first member 12 and the second member 14 are come into contact with the sintered porous silver film. By heating while applying pressure in the direction of lamination of the laminated body, the joining force between the formed joining layer 13 and the first member 12 as well as the second member 14 increases, and the joining strength of the resulting joined body 11 is enhanced. In the case where pressure is applied in the direction of lamination of the laminated body, it is preferable that the pressure is in a range of 1 MPa to 10 MPa.

According to the sintered porous silver film of the present embodiment configured as described above, since the crystallite size is in a range of 60 nm to 150 nm, the sintered porous silver film has high strength and can be handled as a self-supporting joining material. Furthermore, the silver particles have high sinterability and can form a dense silver particle sintered body having high joining strength by heating at a relatively low temperature. Moreover, since the C₃H₇⁺ ion / Ag⁺ ion ratio is in a range of 0.10 to 0.35, and the C₂H⁻ ion / Ag⁻ ion ratio is in a range of 0.9 to 3.7, the surface of the sintered porous silver film is not easily sulfurized, and the sinterability of silver particles can be maintained for a long period of time. It is also possible to form a dense silver particle sintered body having high joining strength reliably, by heating at a relatively low temperature.

Furthermore, according to the method for producing a joined body of the present embodiment, since the above-mentioned sintered porous silver film is used as the joining material, it is possible to produce a joined body having high joining strength (shear strength) by heating at a relatively low temperature.

The embodiments of the present invention have been described above; however, the present invention is not intended to be limited to these embodiments and can be modified as appropriate to the extent that the technical features of the invention are maintained.

In the method for producing the joined body 11 of the present embodiment, a laminated body is produced in the laminated body production step S11, by laminating a first member 12, a sintered porous silver film, and a second member 14 in this order; however, the method is not limited thereto. For example, in the case where an insulated circuit board such as a DBA board or a DBC board is used as the first member 12, a sintered porous silver film-attached insulated circuit board (insulated circuit board having a sintered porous silver film) in which a sintered porous silver film is formed on the surface of an insulated circuit board, is prepared. It is also acceptable to produce a laminated body by disposing a second member 14 on the sintered porous silver film of this sintered porous silver film-attached insulated circuit board. The sintered porous silver film-attached insulated circuit board can be produced by the following method. A silver paste is applied on the surface of an insulated circuit board; and thereby, a silver paste film is formed. Next, the silver paste film is heated; and thereby, the solvent of the silver paste film is removed, and also, the silver particles are partially sintered. Thus, a sintered porous silver film-attached insulated circuit board (insulated circuit board having a sintered porous silver film) can be produced.

### EXAMPLES

Next, the effects of the present invention will be described by Examples.

### <Production of silver powder>

### (Class I)

An aqueous solution of silver nitrate (concentration of silver nitrate: 66% by mass) as an aqueous solution of a silver salt, an aqueous solution of glycolic acid (concentration of glycolic acid: 56% by mass) as an aqueous solution of a carboxylic acid, and an aqueous solution of hydrazine (concentration of hydrazine: 58% by mass) as an aqueous solution of a reducing agent were prepared.

Into a glass container containing 1,200 g of ion-exchanged water that had been kept at 50°C, 900 g of an aqueous solution of silver nitrate kept at 50°C and 600 g of an aqueous solution of glycolic acid kept at 50°C were simultaneously dripped for 5 minutes using a tube pump, and a silver glycolate slurry was prepared. The prepared silver glycolate slurry was air-cooled; and thereby, the temperature was lowered to 20°C.

Next, while the silver glycolate slurry was maintained at 20°C, 300 g of an aqueous solution of hydrazine kept at 20°C was dripped to the silver glycolate slurry for 30 minutes using a tube pump, and thus a mixed slurry was prepared.

Next, the mixed slurry was heated to a temperature of 92°C at a rate of temperature increase of 15°C/hour and was heat-treated under the conditions of maintaining at 92°C (highest temperature) for 0.33 hours; and thereby, a silver powder slurry was obtained. The temperature of the obtained silver powder slurry was lowered to 30°C for 15 minutes. Next, the silver powder slurry was introduced into a centrifuge and was subjected to a centrifugal separation treatment for 10 minutes at a speed of rotation of 1,000 rpm. A supernatant liquid (liquid layer) was removed, the remaining solid content (silver powder) was washed with water and then dried by a freeze-drying method for 30 hours, and a silver powder was collected. The collected silver powder was designated as silver powder of Class I.

### (Class 11)

A silver powder of Class II was obtained in the same manner as in the case of Class I, except that an aqueous solution of formic acid (concentration of formic acid: 58% by mass) was used as the aqueous solution of a reducing agent.

### (Class III)

A silver powder of Class III was obtained in the same manner as in the case of Class I, except that an aqueous solution of ammonium citrate (concentration of citric acid: 56% by mass) was used as the aqueous solution of a carboxylic acid, and an aqueous solution of ammonium formate (concentration of formic acid: 58% by mass) was used as the aqueous solution of a reducing agent.

### (Class IV)

A silver powder of Class IV was obtained in the same manner as in the case of Class I, except that an aqueous solution of malonic acid (concentration of malonic acid: 56% by mass) was used as the aqueous solution of a carboxylic acid, and an aqueous solution of sodium ascorbate (concentration of ascorbic acid: 58% by mass) was used as the aqueous solution of a reducing agent.

### (Class V)

A silver powder of Class V was obtained in the same manner as in the case of Class I, except that an aqueous solution of sodium citrate (concentration of citric acid: 56% by mass) was used as the aqueous solution of a carboxylic acid, and an aqueous solution of ammonium formate (concentration of formic acid: 58% by mass) was used as the aqueous solution of a reducing agent.

### (Class VI)

A silver powder of Class VI was obtained in the same manner as in the case of Class I, except that the mixed slurry was heat-treated under the conditions of raising the temperature to 95°C at a rate of temperature increase of 15°C/hour and maintaining at 95°C (highest temperature) for 0.5 hours.

### (Class VII)

As a silver powder of Class VII, a commercially available silver powder (manufactured by Mitsui Mining & Smelting Co., Ltd., "HP02") was prepared.

### <Evaluation of silver powder>

For the silver powders of Classes I to VII, the average particle size of the silver particles, the C₃H₃O₃⁻ ion / Ag⁺ ion ratio, and the C₆H₆O₈⁻ ion / Ag⁺ ion ratio were measured by the following methods. The results are shown in the following Table 1. In Table 1, the types of the various materials used for the production of a silver powder and the heat treatment conditions (highest temperature, retention time) of a mixed slurry are described together.

### (Average particle size of silver particles)

A silver powder was mixed with an epoxy resin, the obtained mixture was cured, and thus a sample for measuring the silver particle size was produced. The central portion of this sample for measuring the silver particle size was cut out, and the cut surface was polished using an argon ion beam. The processed surface which was polished was observed with a scanning electron microscope (SEM), and 1,000 or more silver particles were randomly selected. For the selected silver particles, the diameter in a direction along the direction of irradiation of the argon ion beam was measured as the particle diameter, and the average value of the particle diameters was taken as the average particle size of the silver particles.

### (C₃H₃O₃⁻ ion / Ag⁺ ion ratio and C₆H₆O₈⁻ ion / Ag⁺ ion ratio)

The detected amounts of Ag⁺ ions, C₃H₃O₃⁻ ions, and C₆H₆O₈⁻ ions were measured by time-of-flight secondary ion mass spectrometry. A sample for measurement was obtained by embedding a silver powder in the surface of an In foil. For the measuring apparatus, nanoTOFII manufactured by ULVAC-PHI, Inc. was used. measurement was conducted under conditions where the measurement range was a range of 100 µm square, the primary ion was Bi₃⁺⁺ (30 kV), and the measurement time was 5 minutes, and thus a TOF-SIMS spectrum was obtained. From the obtained TOF-SIMS spectrum, the detected amounts of Ag⁺ ions, C₃H₃O₃⁻ ions, and C₆H₆O₈⁻ ions were determined, the detected amounts of C₃H₃O₃⁻ ions and C₆H₆O₈⁻ ions were respectively divided by the detected amount of Ag⁺ ions; and thereby, the C₃H₃O₃⁻ ion / Ag⁺ ion ratio and the C₆H₆O₈⁻ ion / Ag⁺ ion ratio were calculated.

**Table 1**

| Class | Production conditions for silver powder | | | | | Silver powder | | |
|---|---|---|---|---|---|---|---|---|
| | Type of silver salt | Type of carboxylic acid | Type of reducing agent | Heat treatment conditions for mixed slurry | | Average particle size of silver particles (nm) | Amount of organic compound | |
| | | | | Highest temperature (°C) | Retention time (hour) | | C₃H₃O₃⁻ ion / Ag⁺ ion | C₆H₆O₈⁻ ion / Ag⁺ ion |
| I | Silver nitrate | Glycolic acid | Hydrazine | 92 | 0.33 | 50 | 0.2 | 0.01 |
| II | Silver nitrate | Glycolic acid | Formic acid | 92 | 0.33 | 50 | 0.3 | 0.01 |
| III | Silver nitrate | Ammonium citrate | Ammonium formate | 92 | 0.33 | 50 | 0.3 | 0.01 |
| IV | Silver nitrate | Malonic acid | Sodium ascorbate | 92 | 0.33 | 50 | 0.4 | 0.01 |
| V | Silver nitrate | Sodium citrate | Ammonium formate | 92 | 0.33 | 50 | 0.3 | 0.01 |
| VI | Silver nitrate | Glycolic acid | Hydrazine | 95 | 0.5 | 50 | 0.5 | 0.005 |
| VII | Commercially available silver powder | | | | | 200 | Not detected | Not detected |

### <Invention Example 1>

### [Production of sintered porous silver film]

The silver powder of Class I as a silver powder and ethylene glycol as an organic solvent were respectively weighed such that the mixing amounts in parts by mass became 85:15, and the materials were introduced into a container. Next, an operation of rotating the container for 5 minutes at a speed of rotation of 2,000 rpm was conducted three times using a kneading machine (manufactured by THINKY Corporation, "AWATORI NENTARO"), thus the silver powder and the organic solvent were kneaded; and thereby, a silver paste was prepared (silver paste preparation step S01).

The silver paste was printed on a glass substrate using a metal mask plate having a size of 2.5 mm × 2.5 mm × thickness of 0.05 mm; and thereby, a silver paste film having a thickness of 0.05 mm was formed (silver paste film forming step S02). Next, the glass substrate on which the silver paste film was formed was introduced into a blowing dryer, the silver paste film was dried under sintering conditions where a heating temperature was 150°C and a heating time was 15 minutes, the silver particles were partially sintered; and thereby, a sintered porous silver film was produced (sintering step S03). After heating, the glass substrate was taken out from the blowing dryer and was left to cool to room temperature. Next, the sintered porous silver film was peeled off from the glass substrate; and thereby, a sintered porous silver film was obtained. The film thickness of the obtained sintered porous silver film was 0.04 mm.

### [Production of joined body]

A silicon element (2.5 mm × 2.5 mm) of which the bottom face was sputtered with silver, and a copper plate (2.5 mm × 2.5 mm) plated with silver were prepared. The silver-sputtered bottom face of the silicon element and the silver-plated surface of the copper plate were laminated, with the above-mentioned sintered porous silver film interposed therebetween, and thus a laminated body was obtained (laminated body production step S11). The obtained laminated body was heated from room temperature up to 200°C at a rate of temperature increase of 30°C/minute in an air atmosphere while a load of 10 MPa was applied in the direction of lamination using a pressure die bonder, and then was heated at 200°C for 15 minutes. Thus, a joined body was obtained (heating step S12). With regard to the obtained joined body, the film thickness of the joining layer was 0.03 mm.

### <Invention Examples 2 to 8 and Comparative Examples 1 to 5>

In the silver paste preparation step S01, a silver paste was obtained in the same manner as Invention Example 1, except that a silver powder of the class shown in the following Table 2 was used as the silver powder. Next, in the sintering step S03, a sintered porous silver film was produced in the same manner as Invention Example 1, except that the sintering conditions were set to the heating temperature and the heating time shown in the following Table 2. Then, a joined body was produced using the obtained sintered porous silver film in the same manner as Invention Example 1. However, in Comparative Examples 4 and 5, a sintered porous silver film could not be produced; and therefore, a joined body could not be produced. With regard to the joined bodies obtained in Invention Examples 2 to 8 and Comparative Examples 1 to 3, the film thickness of the joining layer was 0.03 mm.

### <Evaluation of sintered porous silver film and joined body>

With regard to the sintered porous silver films obtained in Invention Examples 1 to 8 and Comparative Examples 1 to 3, the filling ratio, the crystallite size, the C₃H₇⁺ ion / Ag⁺ ion ratio, and C₂H⁻ ion / Ag⁻ ion ratio were respectively measured by the following methods. With regard to the joined bodies, the shear strength was measured by the following method. The results are presented in the following Table 2.

### (Filling ratio)

The filling ratio was determined from a cross-sectional image of a sintered porous silver film. First, a cross section of the sintered porous silver film was subjected to CP (Cross section Polish) processing. Next, an image of a cross-section of the sintered porous silver film was captured using SEM at 1,000-fold magnification. The obtained cross-sectional image was binarized using an image processing software program (Image J). In the binarized image, the area of a silver portion displayed in white was measured, and the area proportion occupied by the silver portion in the entire visual field was calculated as the filling ratio.

### (Crystallite size)

The crystallite size was determined from an X-ray diffraction pattern. The X-ray diffraction pattern was measured under the following measurement conditions using an X-ray diffractometer (manufactured by Bruker AXS, Inc., D8 ADVANCE).

### Measurement conditions

Target: Cu
Tube voltage: 40 kV
Tube current: 40 mA
Irradiated X-ray size: 2 mmϕ or less
Scan range: 30 to 140 deg.
Step width: 0.02 deg.

The obtained X-ray diffraction pattern was analyzed by the Pawley method using an analysis software program (manufactured by Bruker AXS, Inc., TOPAS: Version 5), and the crystallite size of silver particles was calculated from the Lorentz function component. Upon the analysis of the X-ray diffraction pattern, the profile function was fixed to a value determined using an X-ray diffraction pattern of a standard sample (NIST SRM640d), which had been measured in advance.

### (C₃H₇⁺ ion / Ag⁺ ion ratio and C₂H⁻ ion / Ag⁻ ion ratio)

The detected amounts of Ag⁺ ions, Ag⁻ ions, C₃H₇⁺ ions, and C₂H⁻ ions were measured by time-of-flight secondary ion mass spectrometry (TOF-SIMS). A sample for measurement was obtained by embedding the sintered porous silver film in the surface of an In foil. The measuring apparatus and the measurement conditions are the same as those for the method for measuring the C₃H₃O₃⁻ ion / Ag⁺ ion ratio and the C₆H₆O₈⁻ ion / Ag⁺ ion ratio as described above.

### (Shear strength)

The shear strength was measured by the following method. The force required for breaking the joining layer formed between the copper plate and the silicon element was measured by a bonding tester (manufactured by RHESCA Co., Ltd.). This measured value was divided by the joining area (area of the bottom face of the silicon element); and thereby, the shear strength was obtained. Seven joining layers were produced, and measurement was conducted by a similar procedure. The average value of the measured values was divided by the joining area; and thereby, the shear strength was obtained.

### <Reference Example 1>

The silver paste prepared in Invention Example 1 was applied on the surface of a copper plate (25 mm × 25 mm) that had been subjected to silver plating, using a metal mask plate having a size of 2.5 mm × 2.5 mm × thickness of 0.05 mm; and thereby, a silver paste layer having a thickness of 0.05 mm was formed. Next, the silver-sputtered bottom face of the silicon element (2.5 mm × 2.5 mm) of which the bottom face was sputtered with silver was superposed on this silver paste layer. Thereby, a laminated body in which the surfaces of the silicon element and the copper plate were laminated, with the silver paste layer interposed therebetween, was obtained. The obtained laminated body was heated at 200°C for 15 minutes in an air atmosphere while a load of 10 MPa was applied in the direction of lamination using a pressure die bonder; and thereby, a joined body was obtained. With regard to the obtained joined body, the film thickness of the joining layer was 0.03 mm.

The shear strength of the obtained joined body was measured in the same manner as the above-described method. The results are presented in the following Table 2.

**Table 2**

| | Silver paste | | | | Sintering conditions for silver paste film | | Sintered porous silver film | | | | Joined body |
|---|---|---|---|---|---|---|---|---|---|---|---|
| | Silver powder | | Organic solvent | | Heating temperature (°C) | Heating time (min) | Filling ratio (%) | Crystallite size of silver (nm) | Amount of organic compound | | Shear strength (MPa) |
| | Class | Mixing amount (mass%) | Type | Mixing amount (mass%) | | | | | C₃H₇⁺ ion / Ag⁺ ion | C₂H⁻ ion / Ag⁻ ion | |
| Invention Example 1 | I | 85 | Ethylene glycol | 15 | 150 | 15 | 60 | 80 | 0.35 | 3.7 | 60 |
| Invention Example 2 | II | 85 | Ethylene glycol | 15 | 150 | 5 | 60 | 80 | 0.30 | 3.6 | 40 |
| Invention Example 3 | III | 85 | Ethylene glycol | 15 | 150 | 30 | 60 | 80 | 0.20 | 2.5 | 40 |
| Invention Example 4 | IV | 85 | Ethylene glycol | 15 | 150 | 15 | 60 | 80 | 0.35 | 3.7 | 70 |
| Invention Example 5 | V | 85 | Ethylene glycol | 15 | 150 | 15 | 60 | 80 | 0.35 | 3.7 | 60 |
| Invention Example 6 | VI | 85 | Ethylene glycol | 15 | 150 | 15 | 60 | 80 | 0.35 | 3.7 | 60 |
| Invention Example 7 | I | 85 | Ethylene glycol | 15 | 100 | 60 | 55 | 60 | 0.30 | 3.6 | 40 |
| Invention Example 8 | I | 85 | Ethylene glycol | 15 | 200 | 15 | 65 | 150 | 0.10 | 0.9 | 40 |
| Comparative Example 1 | I | 85 | Ethylene glycol | 15 | 100 | 1 | 60 | 80 | 0.70 | 5.5 | 20 |
| Comparative Example 2 | I | 85 | Ethylene glycol | 15 | 200 | 60 | 60 | 80 | 0.05 | 0.5 | 20 |
| Comparative Example 3 | I | 85 | Ethylene glycol | 15 | 300 | 15 | 75 | 200 | 0.05 | 0.5 | 15 |
| Comparative Example 4 | I | 85 | Ethylene glycol | 15 | 80 | 15 | - | 55 | 0.50 | 5.0 | - |
| Comparative Example 5 | VII | 85 | Ethylene glycol | 15 | 150 | 15 | - | 200 | Not detected | Not detected | - |
| Reference Example 1 | I | 85 | Ethylene glycol | 15 | - | | | | | | 30 |

In the sintered porous silver film of Comparative Example 1, the C₃H₇⁺ ion / Ag⁺ ion ratio and the C₂H⁻ ion / Ag⁻ ion ratio were higher than the ranges of the present embodiment. A joined body produced using this sintered porous silver film of Comparative Example 1 had lower shear strength than that of the joined body of Reference Example 1 produced using a silver paste. This is considered to be because the amount of the organic compound coating the sintered porous silver film was large; and thereby, the sinterability of the silver particles was deteriorated.

In the sintered porous silver film of Comparative Example 2, the C₃H₇⁺ ion / Ag⁺ ion ratio and the C₂H⁻ ion / Ag⁻ ion ratio were lower than the ranges of the present embodiment. A joined body produced using this sintered porous silver film of Comparative Example 2 had lower shear strength than that of the joined body of Reference Example 1 produced using a silver paste. This is considered to be because the amount of the organic compound coating the sintered porous silver film was small; and thereby, from the time at which the sintered porous silver film had been produced until the time at which the joined body had been produced, the surface of the sintered porous silver film was sulfurized, and it became difficult for the silver particles to be sintered.

In the sintered porous silver film of Comparative Example 3, the crystallite size was larger than the range of the present embodiment, and the C₃H₇⁺ ion / Ag⁺ ion ratio and the C₂H⁻ ion / Ag⁻ ion ratio were lower than the ranges of the present embodiment. A joined body produced using this sintered porous silver film of Comparative Example 3 had further lower shear strength than that of the joined body of Reference Example 1 produced using a silver paste. This is considered to be because the surface of the sintered porous silver film was sulfurized, and in addition, the crystallite size was coarse; and thereby, the sinterability of the silver particles was greatly deteriorated.

In Comparative Example 4, the heating temperature for the silver paste film was set to 80°C; however, the heating temperature became too low so that the silver particles were sintered only partially, the crystallite size was small, and the amount of the organic compound was large. Therefore, a self-supporting sintered porous silver film was not obtained. Therefore, any measurement other than the crystallite size of silver and the amount of the organic compound was not conducted.

Furthermore, in Comparative Example 5, a silver powder having an average particle size of the silver particles of 200 nm was used; however, the sinterability of silver particles was low, sintering of the silver particles did not proceed at a heating temperature of 150°C, and a self-supporting sintered porous silver film was not obtained. The crystallite size of silver also became large. Therefore, any measurement other than the crystallite size of silver and the amount of the organic compound was not conducted.

In contrast, with regard to joined bodies produced using the sintered porous silver films of Invention Examples 1 to 8 in which the crystallite size was in the range of the present embodiment and the C₃H₇⁺ ion / Ag⁺ ion ratio and the C₂H⁻ ion / Ag⁻ ion ratio were in the ranges of the present embodiment, it was verified that the shear strength was higher than that of the joined body of Reference Example 1 produced using a silver paste. This is considered to be because in the sintered porous silver films of Invention Examples 1 to 8, the organic solvent did not volatilize during heating at the time of producing the joined body; and thereby, pores were not likely to be generated inside the film, and a dense joining layer was formed.

For example, in the case where the measured value of shear strength is 65 MPa, there is a variation of about -5 MPa to + 5 MPa in the measured value of shear strength. Therefore, it can be said that the shear strength of 60 MPa of Invention Examples 1, 5, and 6 and the shear strength of 70 MPa of Invention Example 4 are almost the same value.

In Invention Examples 2 and 3, the amount of the organic compound was different; however, the shear strength was the same. It is presumed that this is because in Invention Examples 2 and 3, no significant difference occurred in the sinterability.

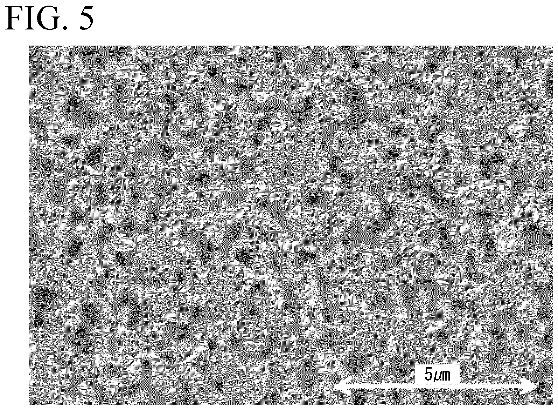

A cross-section of the sintered porous silver film produced in Invention Example 1 in a state of being embedded in a resin was polished; and thereby, the cross-section of the sintered porous silver film was exposed. The cross-section was observed using SEM. FIG. 4 shows a SEM photograph of a cross-section of the sintered porous silver film. Furthermore, a cross-section of a joined body produced using the sintered porous silver film in Invention Example 1 in a state of being embedded in a resin was polished; and thereby, a cross-section of the joining layer was exposed. The cross-section was observed using SEM. FIG. 5 shows a SEM photograph of a cross section of the joining layer.

From the SEM photograph of the sintered porous silver film of FIG. 4, it was verified that the sintered porous silver film had a structure in which silver particles were partially sintered and continuous pores were formed between the partially sintered silver particles. Furthermore, from the SEM photograph of the joining layer in FIG. 5, it was verified that in the sintered porous silver film, sintering of silver particles further proceeded as a result of heating, and a dense silver particle sintered body (joining layer) was formed.

### Industrial Applicability

According to the sintered porous silver film of the present embodiment, a joined body including a dense silver particle sintered body (joining layer) having high joining strength can be produced by heating at a relatively low temperature. Therefore, the sintered porous silver film of the present embodiment can be suitably used in a process for producing a joined body by joining two or more components, among processes for assembling and mounting electronic components such as an LED (light emitting diode) element and a power semiconductor chip.

### Explanation of Reference Signs

- 11: Joined body
- 12: First member
- 13: Joining layer
- 14: Second member

## Claims

1. A sintered porous silver film which is obtained by sintering silver particles,
wherein a crystallite size is in a range of 60 nm to 150 nm, a ratio of a detected amount of C₃H₇⁺ ions to a detected amount of Ag⁺ ions which are measured by time-of-flight secondary ion mass spectrometry is in a range of 0.10 to 0.35, and a ratio of a detected amount of C₂H⁻ ions to the detected amount of Ag⁻ ions which are measured by time-of-flight secondary ion mass spectrometry is in a range of 0.9 to 3.7.

2. A method for producing a joined body in which a first member and a second member are joined,
the method comprising:
a step of laminating the first member and the second member, with the sintered porous silver film according to claim 1 interposed therebetween, and thereby obtaining a laminated body; and
a step of heating the laminated body.
